# EUROPÄISCHE PATENTANMELDUNG

(11) **EP 2 053 875 A2**
(43) Veröffentlichungstag der Anmeldung: **29.04.2009**
(21) Anmeldenummer: 08105643.4
(22) Anmeldetag: 23.10.2008
(51) Int. Cl.: H04R 3/14, H04R 5/04

(54) **Lautsprechersystem und Verfahren zum Betreiben des Lautsprechersystems**

(30) Priorität: 25.10.2007 DE 102007051402
(71) Anmelder: Continental Automotive GmbH, 30165 Hannover (DE)
(72) Erfinder: Duennebacke, Joachim, 35745 Herborn (DE); Graf, Christian, 35390 Giessen (DE)

(57) **Zusammenfassung**

Bei einem Lautsprechersystem (1, 1', 1") mit zumindest zwei Hoch-/Mitteltonlautsprechern (2, 4) und zumindest einem Basslautsprecher (6), bei dem die Hoch-/Mitteltonlautsprecher (2, 4) jeweils in einem zugeordneten Mittelhochtonzweig (30, 32) über im Brückenbetrieb geschaltete Verstärker (10, 12, 14, 16) mit Mittelhochtonsignalen angesteuert werden, wobei im ersten Mittelhochtonzweig (30) die gegenphasigen Mittelhochtonsignale aus einem Mittelhochtonanteil (MH) und einem gleichphasigen Bassanteil (B) des Audiosignals in positiver Phasenlage und im zweiten Mittelhochtonzweig (32) die gegenphasigen Mittelhochtonsignale aus einem Mittelhochtonanteil (MH) und einem gleichphasigen Bassanteil (B) des Audiosignals in negativer Phasenlage zusammengesetzt sind, und bei dem die Eingänge des Basslautsprechers (6) jeweils an einen der beiden Mittelhochtonzweige (30, 32) angeschlossen sind, soll eine besonders hohe Klangqualität mit besonders gering gehaltenen Übersprecheffekten gewährleistet sein. Dazu ist erfindungsgemäß eine zur Bereitstellung der Mittelhochtonsignale aus dem Audiosignal vorgesehene Signalverarbeitungseinheit (28) eingangsseitig für jeden der Verstärker (10, 12, 14, 16) mit einem für die Verstärkung in dessen Übertragungsstrecke charakteristischen Kennwert beaufschlagt.

## Beschreibung

Die Erfindung bezieht sich auf ein Lautsprechersystem zur Wiedergabe von Audiosignalen mit zumindest zwei Hoch-/Mitteltonlautsprechern und zumindest einem Basslautsprecher, bei dem die Hoch-/Mitteltonlautsprecher jeweils in einem zugeordneten Mittelhochtonzweig im Brückenbetrieb mit gegenphasigen Mittelhochtonsignalen und zusätzlich mit gleichphasigen Basssignalen angesteuert werden, wobei im ersten Mittelhochtonzweig das Basssignal in positiver Phasenlage und im zweiten Mittelhochtonzweig das Basssignal in negativer Phasenlage vorhanden ist, und bei dem die Eingänge des Basslautsprechers jeweils an einen der beiden Mittelhochtonzweige angeschlossen sind. Sie betrifft weiterhin ein Verfahren zum Betreiben eines derartigen Lautsprechersystems.

In Kraftfahrzeugen werden üblicherweise Lautsprechersysteme eingesetzt, bei denen für jeden verwendeten Lautsprecher entweder eine Frequenzweiche oder eine separate Endstufe vorgesehen ist. Gerade bei Lautsprechersystemen, bei denen Mittel-/Hochtonlautsprecher einerseits und Basslautsprecher andererseits separat und frequenzselektiv angesteuert werden sollen, insbesondere um beispielsweise eine Ortung des Basslautsprechers infolge beigemischter mittel- oder hochfrequenter Anteile zu verhindern, sind dabei üblicherweise für jeden Lautsprecher separate Bauteile wie Frequenzweichen und dergleichen erforderlich. Zusätzlich bedingt allein die Nutzung von separaten Endstufen für jeden Lautsprecher erhöhte Kosten und auch Raumbedarf für das Gesamtsystem.

Um dem zu begegnen, ist aus der WO 03/094572 A1 ein Lautsprechersystem bekannt, mit dem eine frequenzselektive Ansteuerung von Hoch-/Mitteltonlautsprechern und einem zugeordneten Basslautsprecher unter Rückgriff auf eine vergleichsweise geringe Anzahl von Komponenten, nämlich auf lediglich acht Verstärker-Endstufen, möglich ist. Dabei sind die Verstärker-Endstufen jeweils paarweise im Brückenbetrieb geschaltet, wobei jeder der beiden Hoch-/Mitteltonlautsprecher jeweils über einen zugeordneten Mittelhochtonzweig, in den jeweils eines der Endverstärkerpaare im Brückenbetrieb geschaltet ist, angesteuert wird. Jeweils einer der Eingänge des Basslautsprechers ist bei diesem System an jeweils einen der Mittelhochtonzweige angeschlossen. Die Ansteuerung des Basslautsprechers bei einer derartigen Schaltung erfolgt dabei dadurch, dass in einem der Mittelhochtonzweige das Mittelhochtonsignal aus einem Mittelhochtonanteil in Gegenphase und einem gleichphasigen Bassanteil des Audiosignals in positiver Phasenlage zusammengesetzt ist. Im anderen Mittelhochtonzweig ist im Gegensatz dazu das gegenphasige Mittelhochtonsignal aus dem Mittelhochtonanteil und dem gleichphasigen Bassanteil des Audiosignals in negativer Phasenlage zusammengesetzt. Bei einer Beaufschlagung des Basslautsprechers mit diesen solchermaßen zusammengesetzten Mittelhochtonsignalen kompensieren sich somit die Mittelhochtonanteile, wobei die Bassanteile des Audiosignals aufgrund ihrer jeweils gegensätzlichen Phasenlage vollumfänglich am Basslautsprecher anliegen.

Bei einem Lautsprechersystem dieser Art, also insbesondere einem Lautsprechersystem mit einem Basslautsprecher und zwei oder mehreren Mittel-/Hochtonlautsprechern, besteht grundsätzlich der Wunsch nach einer Vermeidung von so genanntem Übersprechen, also nach einer Vermeidung der Beaufschlagung des Basslautsprechers mit mittel- oder hochfrequenten Signalanteilen. Insbesondere ist dabei zu berücksichtigen, dass ein Basslautsprecher aufgrund der abgestrahlten tieffrequenten Signale üblicherweise nicht ortbar ist, wohingegen die Mittel-/Hochtonlautsprecher aufgrund des von ihnen abgestrahlten Frequenzspektrums für den Hörer örtlich zugeordnet werden können. Durch die Beimischung von mittel- oder hochfrequenten Anteilen bei der Ansteuerung des Basslautsprechers würde dieser somit in an sich unerwünschter Weise für den Hörer ortbar. Außerdem können Intermodulationsstörungen sowohl im Basslautsprecher als auch im Mitteltonlautsprecher, wenn dieser mit Basssignalen beaufschlagt wird, auftreten.

Aus diesen und aus anderen Gründen im Hinblick auf eine besonders hohe Wiedergabequalität der Audiosignale besteht daher das Bestreben, ein Übersprechen zwischen den einzelnen Audiokanälen weitgehend zu vermeiden. Der Erfindung liegt daher die Aufgabe zugrunde, ein Lautsprechersystem der oben genannten Art, wie es insbesondere aus der WO 03/094572 A1 bekannt ist, dahingehend zu verbessern, dass eine besonders hohe Klangqualität mit besonders gering gehaltenen Übersprecheffekten erreichbar ist. Des Weiteren soll ein zum Betreiben eines derartigen Lautsprechersystems mit hoher Klangqualität besonders geeignetes Verfahren angegeben werden.

Bezüglich des Lautsprechersystems wird diese Aufgabe erfindungsgemäß dadurch gelöst, dass eine zur Bereitstellung der Mittelhochtonsignale aus dem Audiosignal vorgesehene Signalverarbeitungseinheit eingangsseitig für jeden Verstärker mit einem für die Verstärkung in dessen Übertragungsstrecke charakteristischen Kennwert beaufschlagt ist.

Unter "Signalverarbeitungseinheit" ist hierbei insbesondere die aus der WO 03/094572 A1 entnehmbare Schaltungsanordnung zur Ansteuerung der Verstärker und der Lautsprecher in ihrer Gesamtheit zu verstehen. Im Übrigen wird bzgl. einer möglichen Umsetzung der Signalverarbeitungseinheit in vollem Umfang auf die diesbezügliche Offenbarung der WO 03/094572 A1 verwiesen, die in die vorliegende Offenbarung ausdrücklich miteinbezogen wird ("Incorporation by Reference").

Die Erfindung geht von der Überlegung aus, dass bei dem bekannten Lautsprechersystem ein an sich unerwünschtes Übersprechen zwischen den einzelnen Kanälen und dementsprechend eine Beeinträchtigung der klanglichen Wiedergabequalität insbesondere dadurch entstehen könnte, dass die eingesetzten Verstärker oder Verstärker-Endstufen bauart- oder herstellungsbedingt, also beispielsweise aufgrund von Streuung bei der Serienherstellung, mehr oder weniger geringfügig abweichende oder andersartige Eigenschaften aufweisen könnten. Insbesondere könnte die Verstärkungswirkung der einzelnen Verstärker voneinander abweichen, so dass selbst bei der gleichmäßigen Beaufschlagung mit dem Audiosignal ausgangsseitig von den jeweiligen Verstärkern unterschiedlich verstärkte Signale geliefert werden könnten. Bei der anschließenden Beaufschlagung des Basslautsprechers, bei der die mittel- und hochfrequenten Anteile sich eigentlich vollständig kompensieren sollten, könnte eine derartige Streuung in den Verstärkereigenschaften zu mangelhafter Kompensation und somit zur Durchleitung auch mittel- oder hochfrequenter Signalanteile führen. Über die Streuungen der Endstufenverstärkung hinaus könnten zusätzlich noch weitere Fehlerquellen wie beispielsweise Streuungen in den in den jeweiligen Übertragungsstrecken der Verstärker eingesetzten A-/D-Wandlern, evtl. verwendeten Tiefpassfiltern oder Spannungsteilern bestehen, welche dann ihrerseits ebenfalls die Signaltrennung verschlechtern könnten.

Um diesen möglichen Fehlerquellen entgegenzusteuern und eine besonders zuverlässige Signaltrennung zu ermöglichen, sollten die genannten Effekte daher geeignet kompensiert werden. Dies ist erreichbar, indem bei oder nach der Herstellung des Verstärkersystems die Übertragungscharakteristik für die einzelnen Komponenten in den jeweiligen Übertragungskanälen oder -strecken der einzelnen Verstärker in der Art eines Istwerts ermittelt und anhand dieser kanalweise ermittelten Istwerte eine entsprechende Kompensation vorgesehen wird. Dabei wird für jeden der im Brückenbetrieb in den einzelnen Mittel-/ Hochtonzweigen genutzten Verstärker oder Endstufen ein für die jeweilige Verstärkung der Übertragungsstrecke charakteristischer Kennwert ermittelt, wobei diese Kennwerte beim weiteren Betrieb des Systems zur geeigneten Signalkompensation oder -modifikation innerhalb der den Verstärkern vorgeschalteten Signalverarbeitung herangezogen werden können.

Die angestrebte Signalmodifikation durch die kanalspezifische Berücksichtigung der entsprechenden Verstärker-Kennwerte kann dabei auf besonders einfache Weise und mit besonders gering gehaltenen Mitteln erfolgen, indem der Signalverarbeitungseinheit ein Speicherbaustein zugeordnet ist, in dem für die jeweiligen Verstärker die jeweiligen Kennwerte hinterlegt sind. Beim Betrieb des Lautsprechersystems kann sodann bei der Signalbearbeitung der jeweilige Kennwert aus dem Speicher ausgelesen und geeignet berücksichtigt werden. Bei einem derartigen System können die genannten Kennwerte einmalig nach der Herstellung des Gesamtsystems ermittelt und im Speicher hinterlegt werden, so dass keine weiteren Bauteile oder Komponenten für die genannte Signalmodifikation erforderlich sind.

In alternativer vorteilhafter Weiterbildung und insbesondere um auch bei Systemveränderungen, Reparaturmaßnahmen oder dergleichen eine zuverlässige Signalmodifikation zur Kompensation von Verstärkerstreuungen und dergleichen zu ermöglichen, ist vorteilhafterweise die Berücksichtigung von aktuell, beispielsweise während einer Start- oder Inbetriebnahmephase des Systems, erfassten Kennwerten für die einzelnen Verstärker bei der Signalverarbeitung vorgesehen. Dazu ist die Signalverarbeitungseinheit vorteilhafterweise eingangsseitig mit einem A-/D-Wandler verbunden, der seinerseits eingangsseitig über jeweils eine Gleichrichter-Filter-Einheit mit dem Ausgang jeder der zur Ansteuerung der Hoch-/Mitteltonlautsprecher genutzten Verstärker-Endstufen verbunden ist. Die Signalverarbeitungseinheit kann dabei mit dem A-/D-Wandler insbesondere in zweckmäßiger Ausgestaltung über eine zwischengeschaltete Mikro-Controllereinheit oder einen Prozessrechner verbunden sein, in der kanalweise für den jeweiligen Verstärker der zu berücksichtigende Kennwert ermittelt und bedarfsweise an die Signalverarbeitungseinheit weitergegeben wird.

Der A-/D-Wandler kann dabei in der Art einer Vielkanal-Anordnung über jeweils eine zwischengeschaltete Gleichrichter-Filter-Einheit in der Art einer Parallelschaltung mit sämtlichen der genannten Verstärker verbunden sein. Eine vereinfachte Bauweise ist hierbei aber erreichbar, indem der A-/D-Wandler unter Zwischenschaltung einer Umschalteinheit, die ihrerseits mit den Verstärkern geeignet verbunden ist, angeschlossen ist. Die Gleichrichter-Filter-Einheit kann dabei bedarfsweise geeignet zwischen den A-/D-Wandler und die Umschalteinheit geschaltet sein.

Bezüglich des Verfahrens wird die genannte Aufgabe dadurch gelöst, dass bei der Ermittlung der Mittel-/Hochtonsignale aus dem Audiosignal für jeden Verstärker ein für die Verstärkung in dessen Übertragungsstrecke charakteristischer Kennwert berücksichtigt wird.

Vorteilhafterweise wird der Kennwert dabei als Korrekturfaktor berücksichtigt, wobei in der Art einer multiplikativen Auswertung eine entsprechende Signalverarbeitung erfolgt.

Die mit der Erfindung erzielten Vorteile bestehen insbesondere darin, dass durch die Ermittlung individueller Verstärkungsfaktoren der einzelnen Signalzweige, insbesondere aus dem Verhältnis der festgestellten Eingangs- zur Ausgangsspannung, und eine Berücksichtigung dieser Verstärkungsfaktoren bereits in der Signalverarbeitung Streuungen zwischen den einzelnen Verstärkern, Endstufen oder sonstigen Komponenten bereits im Rahmen der Signalverarbeitung geeignet kompensiert werden können. Ein durch Streuungen zwischen den einzelnen Systemkomponenten bedingtes Übersprechen oder sonstige Beeinträchtigungen der Signalqualität sind damit besonders zuverlässig ausgeschlossen.

Ein Ausführungsbeispiel der Erfindung wird anhand einer Zeichnung näher erläutert. Darin zeigen:

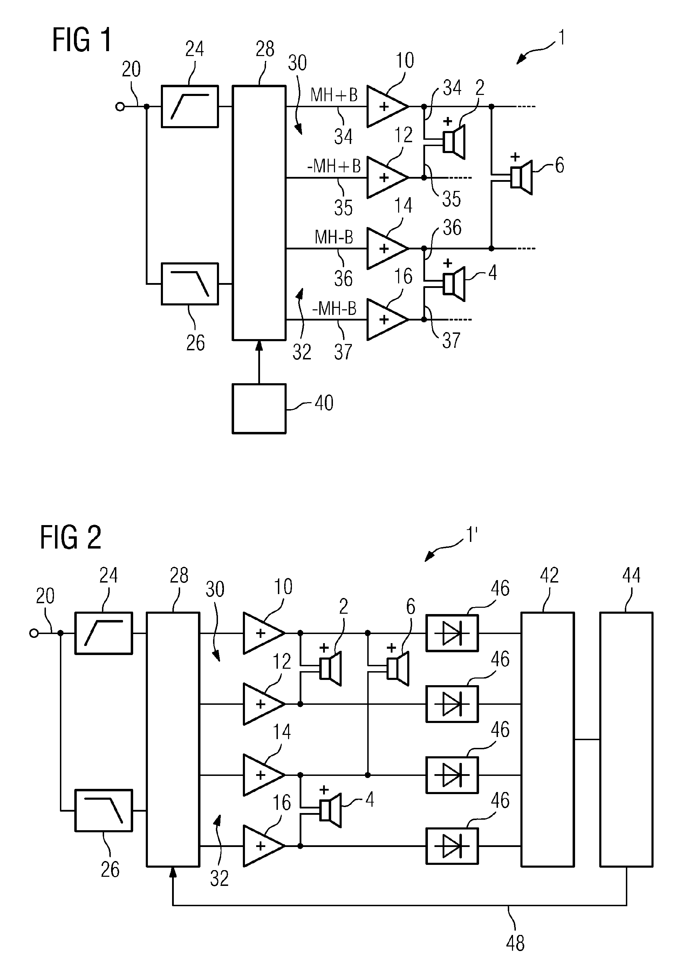

- FIG 1 bis 3: jeweils ein Schaltschema für ein Lautsprechersystem.

Gleiche Teile sind in allen Figuren mit denselben Bezugszeichen versehen.

Das Lautsprechersystem 1, 1', 1" umfasst jeweils zwei Hoch-/Mitteltonlautsprecher 2, 4 und einen Basslautsprecher 6 und ist zum Einsatz in einem Audiosystem eines Kraftfahrzeugs vorgesehen. Das Audiosystem des Kraftfahrzeugs umfasst dabei in der Regel zwei der dargestellten Lautsprechersysteme 1, 1', 1", nämlich in einem Stereosystem eines für den linken und eines für den rechten Kanal.

Das Lautsprechersystem 1, 1', 1" ist für eine vergleichsweise zuverlässige Ansteuerung der drei Lautsprecher mit einer vergleichsweise gering gehaltenen Anzahl von Komponenten gemäß der grundsätzlichen Auslegung des Systems nach der WO 03/094572 A1 ausgelegt, wobei zur Ansteuerung der drei Lautsprecher lediglich vier Endstufen oder Verstärker 10, 12, 14, 16 vorgesehen sind. Dabei sind an einen Eingang 20 für das Audiosignal einerseits ein Hochpassfilter 24 und andererseits ein Tiefpassfilter 26 angeschlossen, die ihrerseits ausgangsseitig mit einer Signalverarbeitungseinheit 28 verbunden sind. Die Signalverarbeitungseinheit 28, die in ihrer konkreten Ausgestaltung nach Maßgabe des Systems gemäß der WO 03/094572 A1 aufgebaut ist, ist ihrerseits ausgangsseitig mit den Verstärkern 10, 12, 14, 16 geeignet verbunden.

Die Hoch-/Mitteltonlautsprecher des Lautsprechersystems 1, 1', 1" sind jeweils in einen zugeordneten Mittelhochtonzweig 30, 32 geschaltet, wobei die Verstärker 10, 12 im ersten Mittelhochtonzweig 30 und die Verstärker 14, 16 im zweiten Mittelhochtonzweig 32 jeweils im Brückenbetrieb dem jeweiligen Hoch-/Mitteltonlautsprecher 2 bzw. 4 vorgeschaltet sind. Die Eingänge des Basslautsprechers 6 sind jeweils an einen der beiden Mittelhochtonzweige 30, 32 angeschlossen. Im ersten Mittelhochtonzweig 30 ist der Verstärker 10 in einer ersten Signalstellung 34 an den ersten Eingang des Hoch-/Mitteltonlautsprechers 2 angeschlossen, an dessen zweiten Eingang der in eine zweite Signalleitung 35 geschaltete Verstärker 12 angeschlossen ist. Analog dazu sind im zweiten Mittelhochtonzweig 32 die Verstärker 14, 16 in Signalleitungen 36, 37 geschaltet, die an die Eingänge des Hoch-/Mitteltonlautsprechers 2 angeschlossen sind.

Beim Betrieb des Lautsprechersystems 1, 1', 1" ist eine frequenzselektive Ansteuerung der Lautsprecher dadurch erreicht, dass in den Signalleitungen 34 bis 37 jeweils aus einem Mittelhochtonanteil MH und einem Bassanteil B zusammengesetzte Audiosignale geführt werden. Diese werden dabei in der Signalverarbeitungseinheit 28 derart erzeugt und zusammengesetzt, dass im ersten Mittelhochtonzweig 30 in der ersten Signalleitung 34 der Mittelhochtonanteil MH und in der zweiten Signalleitung 35 der Mittelhochtonanteil MH gegenphasig dazu, also als -MH, anliegt, wobei beiden jeweils der Bassanteil B in positiver Phasenlage überlagert ist. Die erste Signalleitung 34 wird somit mit dem Signal MH+B und die zweite Signalleitung 35 mit dem Signal -MH+B beaufschlagt. Analog werden im zweiten Mittelhochtonzweig 32 die Signalleitungen 36, 37 mit jeweils gegenphasigen Mittelhochtonanteilen MH, denen jeweils der Basstonanteil B in negativer Phasenlage überlagert ist, beaufschlagt. In der Signalleitung 36 liegt somit das Signal MH-B an, und in der Signalleitung 37 das Signal -MH-B.

Mit anderen Worten: In der Signalverarbeitungseinheit 28 werden die Mittel-/Hochtonsignale für den ersten Mittelhochtonzweig 30 jeweils gegenphasig aus dem Mittelhochtonanteil MH und gleichphasig aus dem Bassanteil B des Audiosignals in positiver Phasenlage zusammengesetzt, wohingegen die Mittel-/Hochtonsignale im zweiten Mittelhochtonzweig 32 aus jeweils gegenphasig dem Mittelhochtonanteil MH und gleichphasig aus dem Bassanteil B des Audiosignals in negativer Phasenlage zusammengesetzt werden. Bei der Beaufschlagung der Eingänge des Basslautsprechers 6 mit den solchermaßen zusammengesetzten Mittel-/Hochtonsignalen aus den Mittelhochtonzweigen 30, 32 kompensieren sich somit die jeweiligen Mittelhochtonanteile MH, wohingegen die Bassanteile B aufgrund ihrer gegensätzlichen Phasenlage vollumfänglich wirksam werden.

Das Lautsprechersystem 1, 1', 1" ist jeweils spezifisch dafür ausgelegt, bei einer derartigen vergleichsweise effizienten Signalverarbeitung ein unerwünschtes Übersprechen zwischen den einzelnen Frequenzanteilen oder Lautsprechern weitgehend zu vermeiden. Dabei ist bei der Auslegung des Lautsprechersystems 1, 1', 1" insbesondere der Erkenntnis Rechnung getragen, dass produktions- oder herstellungsbedingt oder aufgrund sonstiger Stör- oder Fehlerquellen die Verstärker 10, 12, 14, 16 oder auch andere der eingesetzten Komponenten voneinander abweichendes Übertragungs- oder Verstärkungsverhalten aufweisen könnten. Die gewünschte Kompensation der Mittel-/Hochtonsignale bei der Beaufschlagung des Basslautsprechers 6 könnte somit beispielsweise beeinträchtigt werden, wenn die Mittelhochtonanteile MH der eingehenden Signale aufgrund unterschiedlicher Übertragungs- oder Verstärkerfunktionen nicht exakt gleich sind und sich somit nicht vollständig kompensieren. Um dem Rechnung zu tragen, ist im Lautsprechersystem 1, 1', 1" jeweils eine Kompensation von Streuungen im Verstärkerverhalten oder Übertragungsverhalten durch eine Beaufschlagung der Signalverarbeitungseinheit 28 mit geeigneten, für die einzelnen Kanäle charakteristischen Kennwerten vorgesehen.

So ist im Ausführungsbeispiel nach FIG 1 das Lautsprechersystem 1 mit einem Speicher 40 versehen, in dem für jeden der Verstärker 10, 12, 14, 16 ein Verstärkungsfaktor oder ein für die Verstärkung charakteristischer Kennwert hinterlegt ist.

Dieser Kennwert kann für die einzelnen Verstärker 10, 12, 14, 16 beispielsweise unmittelbar nach der Herstellung durch Ermittlung des Verhältnisses Eingangs- zur Ausgangsspannung bestimmt und anschließend im Speicher 40 hinterlegt werden. Das Lautsprechersystem 1 gemäß FIG 1 ist somit bei nur gering gehaltener Anzahl der erforderlichen Komponenten für eine zuverlässige Kompensation der ermittelten Streuungen in den Verstärkungswerten geeignet ausgelegt. Die Kennwerte können natürlich auch in einem schon vorhandenen anderen Speicher abgelegt werden; ebenso kann der Speicher 40 noch zur Hinterlegung weiterer Kennwerte oder zu anderen Speicherzwecken genutzt werden.

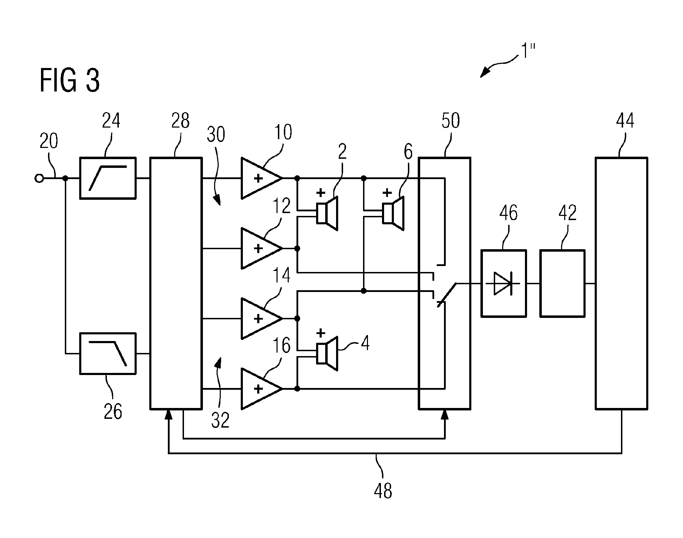

Im Gegensatz oder in Ergänzung dazu sind die Lautsprechersysteme 1, 1', 1'' gemäß den FIG 2, 3 in der Art einer Online-Kompensation für die Ermittlung entsprechender Kennwerte während des Betriebs der jeweiligen Lautsprecheranordnung 1', 1" und einer Berücksichtigung der aktuell ermittelten Kennwerte bei der Signalverarbeitung ausgelegt. Im Lautsprechersystem 1' nach der FIG 2 ist dazu die Signalverarbeitungseinheit 28 eingangsseitig mit einem A-/D-Wandler 42 unter Zwischenschaltung der Prozessoreinheit 44 verbunden. Der A-/D-Wandler 42 ist dabei seinerseits eingangsseitig über jeweils eine zwischengeschaltete Gleichrichter-Filter-Einheit 46 mit jeweils einem der Verstärker 10, 12, 14, 16 verbunden.

Beim Betrieb des Lautsprechersystems 1' werden die gleich gerichteten Spannungen am Ausgang der jeweiligen Verstärker 10, 12, 14, 16 über den A-/D-Wandler 42 an den Eingang der Prozessoreinheit 44 geführt. An die Eingänge der Verstärker 10, 12, 14, 16 werden gleich große Eingangssignale mit entsprechender Frequenz angelegt (beispielsweise aus einem digitalen Signalprozessor oder einer anderen externen Quelle). Über den A-/D-Wandler 42 werden die Ausgangsspannungen der Verstärker 10, 12, 14, 16 gemessen. Aus dem Verhältnis der Eingangs- und der Ausgangsspannungen werden sodann die Verstärkungsfaktoren der einzelnen Signalzweige berechnet und gegebenenfalls in einem zugeordneten Speicher oder in der Prozessoreinheit 44 hinterlegt. Anhand der ermittelten Verstärkungsfaktoren, die von der Prozessoreinheit 44 über die Rückkoppelleitung 48 an die Signalverarbeitungseinheit 28 übermittelt werden, können anschließend die festgestellten Ungleichheiten im Verstärkungsverhalten geeignet korrigiert werden.

Die Messung der Verstärkungsfaktoren kann im Lautsprechersystem 1' bei jedem Starten des Geräts erfolgen. Alternativ können die ermittelten Verstärkungsfaktoren auch in einem Speicher hinterlegt über diesen der Signalverarbeitungseinheit 28 zur Verfügung gestellt werden, wobei eine Aktualisierung der ermittelten Faktoren oder der gespeicherten Kennwerte bedarfsweise manuell oder auch ereignisgesteuert ausgelöst veranlasst werden kann.

Zur Vereinfachung des apparativen Aufbaus ist im Lautsprechersystem 1" gemäß FIG 3 der A-/D-Wandler 42 über einen vorgeschalteten Gleichrichter 46 mit einem Umschalter 50 verbunden, der seinerseits mit sämtlichen Signalkanälen verbunden ist. Durch selektive Ansteuerung der einzelnen Signalkanäle über den Umschalter 50, beispielsweise ausgelöst durch die Signalverarbeitungseinheit 28, kann somit der Verstärkungsfaktor jedes Signalkanals sequentiell ermittelt werden.

## Patentansprüche

1. Lautsprechersystem (1, 1', 1'') mit zumindest zwei Hoch-/Mitteltonlautsprechern (2, 4) und zumindest einem Basslautsprecher (6), bei dem die Hoch-/Mitteltonlautsprecher (2, 4) jeweils in einem zugeordneten Mittelhochtonzweig (30, 32) über im Brückenbetrieb geschaltete Verstärker (10, 12, 14, 16) mit Mittelhochtonsignalen angesteuert werden, wobei im ersten Mittelhochtonzweig (30) die Mittelhochtonsignale jeweils gegenphasig aus einem Mittelhochtonanteil (MH) und gleichphasig aus einem Bassanteil (B) des Audiosignals in positiver Phasenlage und im zweiten Mittelhochtonzweig (32) die Mittelhochtonsignale jeweils gegenphasig aus einem Mittelhochtonanteil (MH) und gleichphasig aus einem Bassanteil (B) des Audiosignals in negativer Phasenlage zusammengesetzt sind, und bei dem die Eingänge des Basslautsprechers (6) jeweils an einen der beiden Mittelhochtonzweige (30, 32) angeschlossen sind,
**dadurch gekennzeichnet, dass**
eine zur Bereitstellung der Mittelhochtonsignale aus dem Audiosignal vorgesehene Signalverarbeitungseinheit (28) eingangsseitig für jeden der Verstärker (10, 12, 14, 16) mit einem für die Verstärkung in dessen Übertragungsstrecke charakteristischen Kennwert beaufschlagt ist.

2. Lautsprechersystem (1, 1', 1") nach Anspruch 1, bei dem die Signalverarbeitungseinheit (28) mit einem Speicher (40) für den Kennwert verbunden ist.

3. Lautsprechersystem (1, 1', 1") nach Anspruch 1 oder 2, bei dem die Signalverarbeitungseinheit (28) eingangsseitig mit einem A-/D-Wandler (42) verbunden ist, der seinerseits eingangsseitig über jeweils eine Gleichrichter-Filter-Einheit (46) mit dem Ausgang jeder der zur Ansteuerung der Hoch-/Mitteltonlautsprecher (2, 4) genutzten Verstärker (10, 12, 14, 16) verbunden ist.

4. Lautsprechersystem (1, 1', 1") nach Anspruch 3, bei dem der A-/D-Wandler (42) eingangsseitig unter Zwischenschaltung einer Umschalteinheit mit den Ausgängen der zur Ansteuerung der Hoch-/Mitteltonlautsprecher (2, 4) genutzten Verstärker (10, 12, 14, 16) verbunden ist.

5. Verfahren zum Betreiben eines Lautsprechersystems (1, 1', 1") nach einem der Ansprüche 1 bis 4,
**dadurch gekennzeichnet, dass**
bei der Ermittlung der Mittelhochtonsignale aus dem Audiosignal für jeden der Verstärker (10, 12, 14, 16) ein für die Verstärkung in dessen Übertragungsstrecke charakteristischer Kennwert berücksichtigt wird.

6. Verfahren nach Anspruch 5, bei dem der Kennwert als Korrekturfaktor berücksichtigt wird.

7. Verfahren nach Anspruch 5 oder 6, bei dem der Kennwert in einem Speicher (40) hinterlegt ist.

8. Verfahren nach einem der Ansprüche 5 bis 7, bei dem der Kennwert während einer Startphase des Betriebs des Lautsprechersystems (1, 1', 1") ermittelt wird.
